# FASCICULE DE BREVET EUROPEEN

(11) **EP 1 482 635 B1**
(45) Date de publication et mention de la délivrance du brevet: **06.08.2008**
(21) Numéro de dépôt: 04018081.2
(22) Date de dépôt: 10.06.1999
(51) Int. Cl.: H03L 7/16

(54) **Chaîne d'émission réception et procédé d'émission**
Sende-Empfänger und Verfahren
Transceiver, and method

(30) Priorité: 11.06.1998 FR 9807340
(43) Date de publication de la demande: 01.12.2004
(62) Demande divisionnaire de: 99401396.9
(73) Titulaire: TCL & ALCATEL MOBILE PHONES LIMITED, China Hong Kong City, 33 Canton Road, Tsim Sha Tsui,Kowloon, Hong Kong (CN)
(72) Inventeur: Yang, Fuji, Holmdel NJ 07733-3030 (US); Genest, Pierre, 31180 Rouffiac Tolosan (FR); Dussauby, Eric, 95320 SAINT LEU LA FORET (FR); Berland, Corinne, 75010 Paris (FR); Maecker, Arnaud, 92600 Asnieres (FR)
(74) Mandataire: Feray, Valérie

(56) Documents cités:
- EP-A- 0 678 974
- GB-A- 2 247 368
- GB-A- 2 278 511
- US-A- 5 038 404
- US-A- 5 128 633

## Description

La présente invention a pour objet une chaîne d'émission réception ainsi qu'un procédé d'émission utilisable notamment dans le domaine de la téléphonie mobile. Le domaine préféré de l'invention est celui de la téléphonie mobile parce que, dans la téléphonie mobile, de type TDMA aussi bien que FDMA, il est nécessaire de provoquer régulièrement des sauts de fréquence d'émission. Du point de vue du système de la téléphonie mobile, ces sauts servent à changer de canal et donc à répartir des bruits présents dans des bandes particulières de fréquence entre plusieurs communications échangées entre des téléphones mobiles et des stations de base. L'invention vise donc à permettre une agilité de fréquence. A ce titre, elle pourrait être aussi utilisée dans le domaine du radar, en contre-mesure par exemple.
Les chaînes d'émission comportent généralement un ensemble de boucles à verrouillage de phase. Chaque boucle à verrouillage de phase est munie d'un oscillateur qui est commandé en tension. Le principe de ces chaînes d'émission est de mélanger les ondes produites par les boucles à verrouillage de phase de manière à produire une onde d'émission. Le document GB 2278511 A décrit une chaîne d'émission-réception utilisant un unique synthétiseur, pour l'émission et pour la réception, ce synthétiseur comportant trois boucles à verrouillage de phase. Dans d'autres cas, on réalise une première boucle dont l'oscillateur oscille à fréquence intermédiaire, par exemple autour de 100 ou 200 MHz, et une deuxième boucle dont l'oscillateur oscille à une fréquence de translation. Par exemple dans le domaine du GSM, la fréquence de translation pourra être de l'ordre de 800 MHz pour conduire à une émission autour de 900 MHz. Dans le cadre du DCS, elle sera de l'ordre de 1700 MHz pour conduire à une émission autour de 1800 MHz. La combinaison de ces deux ondes à fréquence intermédiaire et à fréquence de translation est en général directe. Elle peut également être réalisée dans le cadre d'une troisième boucle. Le signal de la boucle à fréquence intermédiaire sert alors de consigne à un comparateur de phase de la troisième boucle qui reçoit un signal résultant de la soustraction du signal à la fréquence de translation d'un signal à une fréquence d'émission.

Une boucle à verrouillage de phase comporte essentiellement un oscillateur à fréquence variable commandé en tension, relié en sortie à l'entrée d'un diviseur de fréquence. La sortie du diviseur de fréquence est reliée à l'entrée d'un comparateur de phase qui reçoit par ailleurs un signal de consigne à une fréquence à respecter. Le comparateur de phase délivre un signal de commande qui, de préférence, est filtré dans un filtre passe bas. Le signal de commande délivré par le filtre passe bas sert de commande de l'oscillateur commandé en tension. Ce schéma conduit à disposer en sortie de l'oscillateur d'un signal dont la fréquence est un multiple, par un coefficient de division du diviseur de fréquence, de la fréquence du signal injecté en consigne dans le comparateur de phase.

Les sauts de fréquence, correspondant à des multiples d'une largeur de bande de canal normalisée, sont des multiples de valeurs normalisées. Par exemple dans le cadre du GSM, on retient des largeurs de bande de canal de 200 KHz. Les différents canaux sont ainsi espacés les uns des autres selon un pas fréquentiel égal à 200 KHz.

Dans l'état de la technique pour réaliser des sauts de fréquence, il est connu de modifier le coefficient de division du diviseur incorporé dans la boucle de translation de fréquence de façon à provoquer par addition/soustraction les sauts attendus. Par exemple dans le cadre du GSM, avec un pas de 200 KHz, et des fréquences de translation égales à 1700 MHz, le coefficient de division est de l'ordre de 8500. Ce coefficient varie de une ou plusieurs unités selon que le saut de fréquence à réaliser est de une ou plusieurs fois le pas de 200 KHz.

Une telle solution n'est pas totalement satisfaisante parce que, malheureusement, malgré toutes les précautions prises pour sa réalisation, la boucle à fréquence de translation avec diviseur de fréquence conduit à des générations de bruits gênants dans la bande émise. En effet, l'oscillateur et tous les composants présents dans une telle boucle produisent du bruit. Dans les faits, le bruit en sortie d'une telle chaîne d'émission est alors essentiellement proportionnel au coefficient de division du diviseur de la boucle de translation de fréquence.

Dans l'invention on prévoit de remédier à ce problème en réalisant le pas de fréquence recherché pour l'émission, qui doit être de faible valeur (200 KHz dans un exemple préféré), en réalisant une soustraction entre deux pas qui eux-mêmes ne seront pas faibles. Dans un exemple, un premier pas de variation vaudra 5,2 MHz avec une fréquence de comparaison à 2,6 MHz. Un autre pas vaudra 5 MHz avec une fréquence de comparaison à 1 MHz. Par soustraction alors entre ces deux pas de variation, on peut obtenir un pas faible tout en n'ayant jamais eu à provoquer des petites variations de fréquence. Dans l'invention on obtient la soustraction en faisant croître la fréquence de la boucle à fréquence de translation (par le pas de 5,2 MHz), alors qu'on fait décroître la fréquence de la boucle à fréquence intermédiaire (par le pas de 5 MHz). Au moment de l'addition, on obtient un pas de faible valeur (0,2 MHz).

Dans ces conditions on peut montrer que le coefficient de division du diviseur de la boucle de fréquence de translation peut passer de 8500 à 600 environ.

Par ailleurs, lorsqu'on effectue un saut de fréquence, les boucles à verrouillage de phase doivent rallier la nouvelle valeur de fréquence le plus rapidement possible. Or, la vitesse de ralliement de l'asservissement est proportionnelle à la largeur de la bande passante du filtre passe bas relié à la sortie du comparateur. Du fait que la fréquence de comparaison est beaucoup plus élevée avec l'invention, il est possible d'avoir une fréquence de coupure beaucoup plus élevée. Avec une fréquence de coupure de filtre beaucoup plus élevée, le temps de ralliement est alors plus faible. Avec l'invention cette vitesse est alors notablement plus forte et le ralliement est plus rapide du fait d'une fréquence de comparaison beaucoup plus importante choisie dans les boucles elles-mêmes pour les sauts de fréquence.

Enfin, du fait qu'avec l'invention les circuits sont moins bruyants, il est possible de les intégrer sur un même circuit intégré ce qui en réduit énormément le coût et en augmente très fortement la fiabilité.

Un autre problème est rencontré avec les émetteurs récepteurs de téléphones mobiles lorsque le débit d'information est augmenté, notamment dans le cadre de la norme HSCSD-JPRS. En effet, il est généralement réalisé une économie dans ces téléphones mobiles en utilisant, pour la réception, une partie des circuits utilisables pour l'émission. Du fait que les bandes de fréquence d'émission et de réception sont différentes, il est nécessaire d'effectuer un saut de fréquence à la fin d'une fenêtre temporelle d'émission (ou de réception) pour caler le récepteur (ou l'émetteur) autour d'une fréquence de porteuse différente d'une porteuse d'émission (ou de réception). Par ailleurs, il est prévu que dans le cas des transmissions à grand débit (56 Kbits/s), un émetteur puisse émettre pendant deux, voire plusieurs, fenêtres temporelles successives au sein d'une même trame de type GSM. Dans ce cas, le temps restant pour effectuer le saut de fréquence entre la porteuse d'émission et celle de réception, ou réciproquement, se réduit. Il peut par exemple devenir aussi court qu'une seule fenêtre GSM (et non plus égal au moins à un temps de trame). Dans ce cas, le temps de ralliement, même amélioré comme ci-dessus est encore trop long.

Dans l'invention on prévoit de munir la chaîne d'émission réception d'une boucle à verrouillage de phase dédiée à la réception et de deux oscillateurs commandés en tension. Un de ces oscillateurs sert pour l'émission, l'autre pour la réception. Il est possible alors d'anticiper sur l'instant de calage d'une boucle de verrouillage de phase pour démarrer le ralliement. De cette façon on résout le problème de la stabilisation en fréquence des signaux de porteuse au moment voulu.

L'invention a donc pour objet une chaîne d'émission réception, notamment pour un téléphone mobile, telle que définie dans la revendication 1.

L'invention sera mieux comprise à la lecture de la description qui suit et à l'examen des figures qui l'accompagnent. Celles-ci ne sont données qu'à titre indicatif et nullement limitatif de l'invention. Les figures montrent :
- Figure 1 : une représentation fonctionnelle d'une chaîne d'émission selon l'invention comportant par ailleurs un démodulateur associé et réalisé sur un circuit intégré ;
- Figure 2 : un tableau montrant les évolutions des coefficients diviseurs dans les boucles à fréquence intermédiaire et à fréquence de translation, les écarts de fréquence correspondants obtenus, et la fréquence d'émission qui en résulte ;
- Figure 3 : une chaîne selon l'invention comparable à celle de la figure 1 dans laquelle le circuit de réception a été modifié.

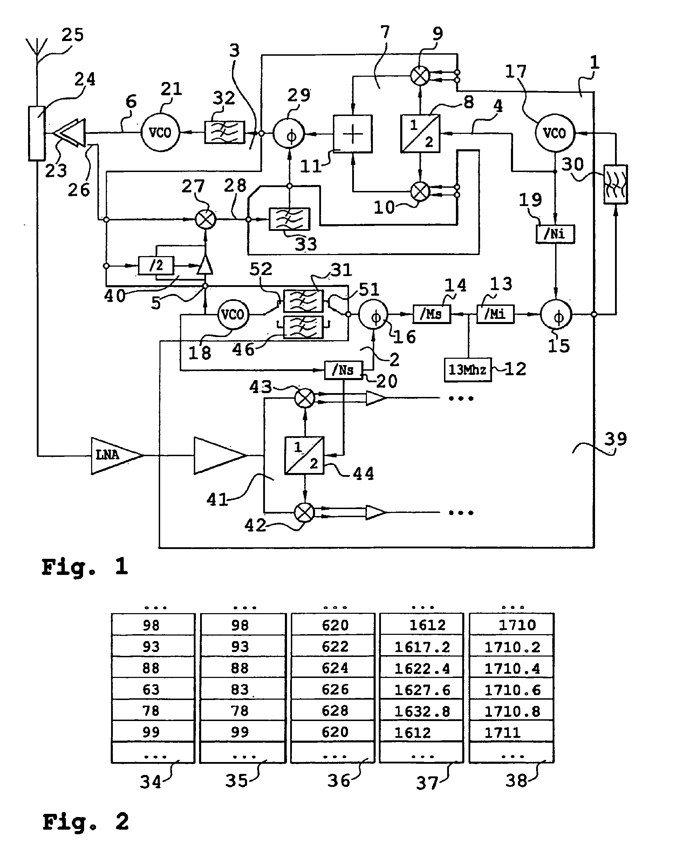

La figure 1 montre une chaîne d'émission conforme à l'invention. Cette chaîne d'émission est notamment destinée à une utilisation dans le domaine de la téléphonie mobile. Cette chaîne comporte trois boucles à verrouillage de phase notées 1 à 3. La première boucle 1 est une boucle dite à fréquence intermédiaire et elle produit à sa sortie 4 un signal à une fréquence intermédiaire. La seconde boucle 2 est une boucle à une fréquence de translation et produit à sa sortie 5 un signal à une fréquence de translation. La troisième boucle est la boucle d'émission, elle produit à sa sortie 6 un signal à une fréquence d'émission. Dans un exemple, le signal disponible à la sortie 4 aura une fréquence de l'ordre de 100 MHz, celui disponible à la sortie 5 aura une fréquence de l'ordre de 1700 MHz. La valeur de la fréquence d'émission est ainsi formée additivement par la valeur de la fréquence intermédiaire et de la fréquence de translation. Dans le cadre du DCS la fréquence d'émission vaut ainsi de l'ordre de 1800 MHz (avec des variations selon les allocations de fréquences accordées à un opérateur de télécommunications). Dans le cadre du GSM ces valeurs doivent être modifiées pour que la fréquence d'émission vaille 900 MHz.

Il serait toutefois possible d'obtenir la fréquence d'émission par une soustraction, par la valeur de la fréquence intermédiaire, de la valeur de la fréquence de translation. On retiendra néanmoins dans ce cas la terminologie de formation additive puisque la fréquence de translation serait alors le résultat de l'addition de la fréquence d'émission et de la fréquence intermédiaire.

La chaîne d'émission de l'invention comporte par ailleurs un circuit modulateur 7 interposé dans les liaisons entre ces boucles. Dans l'exemple représenté, le circuit modulateur 7 est interposé dans la liaison entre la boucle 1 et la boucle 3. Il pourrait néanmoins être interposé entre n'importe quelles boucles. Le but est de moduler le signal disponible à la fréquence d'émission par un signal modulant à émettre. Le signal modulant à émettre représente l'information. Il est ici un signal analogique à deux composantes I et Q (ainsi que ses valeurs complémentaires NI et NQ).

Dans le circuit modulateur 7, le signal à fréquence intermédiaire disponible à la sortie 4 est introduit sur un déphaseur par 90 degrés 8 dont les sorties, déphasées de 90° l'une de l'autre, attaquent respectivement des mélangeurs 9 et 10. D'une manière connue, le déphaseur par 90° comporte un double diviseur de fréquence par deux déclenchés respectivement par un front montant et un front descendant du signal à fréquence intermédiaire. En pratique, la fréquence du signal à fréquence intermédiaire retenu est, pour cette raison, le double de celle évoquée jusqu'ici. Cependant cette précision n'enlève rien à la généralité de l'invention puisqu'il suffit pour la réalisation de la chaîne de l'invention de doubler toutes les valeurs relatives à la première boucle. Les composantes déphasées de 90° du signal à fréquence intermédiaire se mélangent aux signaux I et Q respectivement. Les sorties des mélangeurs 9 et 10 sont combinées ensemble dans un additionneur 11 qui délivre un signal modulé.

Tout autre type de circuit modulateur serait bien entendu envisageable. Notamment la place de ce circuit modulateur pourrait être différente. Dans certains cas, le circuit modulateur est placé dans la boucle d'émission

Le calage en fréquence des boucles 1 et 2 est obtenu par la production d'un signal de référence produit par un circuit de référence 12. Dans un exemple préféré, qu'on utilisera jusqu'à la fin de cet exposé pour simplifier l'explication, le signal produit par la référence 12 a une fréquence Fret de 13 MHz. Ce signal pourrait cependant avoir n'importe quelle autre valeur. Dans un exemple le circuit 12 de référence comporte un quartz. Le signal de la référence 12 est introduit, en particulier par l'intermédiaire de diviseurs 13 et 14, de valeur respectivement Mi et Ms, sur les entrées de consignes de comparateurs de phase 15 et 16 des boucles 1 et 2 respectivement. Les comparateurs de phase 15 et 16 reçoivent par ailleurs des signaux de sorties délivrés par deux oscillateurs commandés en tension 17 et 18 de ces boucles et qui ont été divisés par des diviseurs 19 et 20 de valeur Ni et Ns dans les boucles 1 et 2 respectivement.

En supposant que le coefficient Mi vaille 13, le signal disponible à la sortie du diviseur 13 aura alors une fréquence de 1 MHz. Le signal délivré par le comparateur de phase 15 va donc commander l'oscillateur 17 de telle façon que le résultat de la division par Ni du signal produit par cet oscillateur 17 soit lui aussi un signal à 1 MHz. En conséquence le signal disponible sur la sortie 4 aura une fréquence de Ni x 1MHz. Autrement dit le fonctionnement d'une boucle est de produire en sortie un signal dont la fréquence est le produit de la fréquence du signal de consigne par le coefficient de division de la boucle. Dans la boucle 1, l'oscillateur 17 comporte d'une manière connue une sortie reliée à l'entrée du diviseur 19 et à l'entrée du circuit modulateur 7. Cette sortie délivre le signal à la fréquence intermédiaire.

Dans l'état de la technique, compte tenu de la nécessité d'avoir un pas de faible valeur pour les sauts de fréquence, de 200 KHz dans un cas préféré, la fréquence du signal de consigne de la boucle 2 de translation de fréquence devait être obligatoirement affichée à cette faible valeur. Dans ces conditions le coefficient Ns de division du diviseur 20 était élevé. Dans un exemple il valait 8500 pour transformer un signal à 1700 MHz en un signal avec une fréquence comparable à 200 KHz.

Dans l'invention, on agit complètement différemment en constatant que la fréquence d'émission disponible à la sortie 6 est le résultat de l'addition de la fréquence du signal disponible à la sortie 4 avec la fréquence du signal disponible à la sortie 5. Dans ces conditions, on choisit de faire croître la fréquence du signal disponible à la sortie 5, avec un pas grand. Dans un exemple on a choisi 5,2 MHz pour ce pas grand avec une fréquence de comparaison de 2,6 MHz. Par compensation, on choisit alors de faire décroître la fréquence du signal fourni par l'autre boucle, la boucle 1, avec également un pas grand. Dans l'état de la technique, la boucle 1 de régulation à fréquence intermédiaire avait une valeur fixe en fréquence. Dans l'invention le signal disponible dans cette boucle a une fréquence qui varie lors des sauts en fréquence.

L'addition des deux signaux est de préférence provoquée dans la troisième boucle 3 de la manière suivante. La boucle 3 comporte elle aussi un oscillateur 21 commandé en tension. La sortie 6 de l'oscillateur 21 est reliée à un dispositif d'émission comportant un amplificateur 23, un duplexeur 24 et un aérien d'émission 25. Le signal disponible à la sortie 6 est également prélevé par un capteur 26 avant l'amplification. Ce signal prélevé est mélangé dans un mélangeur 27 avec le signal disponible à la sortie 5 de la boucle 2. Le signal résultant du mélange par le mélangeur 27, disponible à une sortie 28 est injecté dans un comparateur de phase 29 où il est comparé au signal délivré par la chaîne d'émission 7, donc, pour ce qui concerne la porteuse de la fréquence d'émission, par la boucle à fréquence intermédiaire 1. Le mélangeur 27 effectue la soustraction et l'addition des fréquences des signaux disponibles à la sortie 6 et à la sortie 5. Avec un filtre passe bas 33 on élimine la composante d'addition. Le signal délivré par le comparateur 29 qui commande l'oscillateur 21 a pour effet que le résultat de cette soustraction doit être égal au signal à la fréquence intermédiaire, au signal de modulation I et Q près.

Les comparateurs de phase 15, 16 et 29 sont reliés aux oscillateurs commandés en tension 17, 18 et 21 par l'intermédiaire de filtres passe bas respectivement 30, 31 et 32. Le filtre 30 a une fréquence de coupure basse de l'ordre de 100 KHz. Le filtre 31 a une fréquence de coupure basse de l'ordre de 100 à 200 KHz. Le filtre 32 a une fréquence de coupure basse de l'ordre de 200 à 300 KHz. En outre, la fréquence de coupure du filtre 33 est de l'ordre de 200 MHz. Les filtres 30 à 33 sont des filtres de boucle.

Dans le circuit représenté, les diviseurs 13 14, 19 et 20 sont essentiellement programmables. On sait facilement réaliser de tels diviseurs utilisant dans leurs principes des compteurs avec remise à zéro automatique et redéclenchement dès qu'ils ont atteint une valeur préenregistrée. Le signal de redéclenchement de ces compteurs représente le signal en fréquence divisée. La valeur préenregistrée représente le coefficient de division.

La figure 2 montre un tableau permettant d'expliquer, d'une manière chiffrée, simplement, le fonctionnement de l'invention. Sur le tableau une première colonne 34 indique des valeurs possibles du coefficient de division Ni du diviseur 19. Une deuxième colonne 35 indique la valeur de la fréquence intermédiaire disponible en conséquence à la sortie 4. Une troisième colonne 36 donne la valeur du coefficient de division du diviseur 20. Une quatrième colonne 37 indique la fréquence du signal à la fréquence de translation disponible à la sortie 5. Une dernière colonne 38 indique la valeur de la fréquence du signal d'émission résultant.

Comme cela a été expliqué, d'une manière préférée, le coefficient Mi du diviseur 13 vaut 13 de façon à ce que la fréquence du signal de consigne admis à l'entrée du comparateur 15 vaille 1 MHz. Mais l'explication reste valable si ce coefficient Mi a une valeur différente.

Si par exemple, première ligne du tableau, le coefficient Ni est fixé à la valeur 98, la fréquence du signal introduit sur l'autre entrée du comparateur 15 vaudra la valeur de la fréquence délivrée par l'oscillateur 17 divisée par 98. Une fois comparé par le comparateur 15, puis filtré par le filtre 30, le signal résultant de la comparaison est réinjecté à titre de commande sur l'oscillateur 17. En pratique si Ni vaut 98, la fréquence du signal disponible à la sortie 4 est un signal à une fréquence de 98 MHz (98x1 MHz).

Dans un exemple préféré le diviseur 14 a un coefficient de division Ms égal à 5. Lui aussi pourrait cependant avoir une autre valeur. En conséquence, le signal admis sur l'entrée de consigne du comparateur de phase 16 vaut 2,6 MHz. Selon un même raisonnement que précédemment, le signal disponible à la sortie 5 de l'oscillateur 18 vaudra cette valeur de consigne, 2,6 MHz, multipliée par le coefficient Ms. Dans un exemple, première ligne du tableau, Ms vaut 620. Ceci conduit à disposer d'un signal à la sortie 5 dont la fréquence vaut 1612 MHz (620x2,6 MHz). Après passage dans la boucle 3 le signal disponible à la sortie 6 du modulateur vaudra 1710 MHz, colonne 38 (1710=98+1612). Ce faisant, par la faiblesse du coefficient Ns, on a mis en oeuvre une des caractéristiques essentielles de l'invention.

On notera que les divisions devant être effectuées par des nombres entiers (le traitement étant effectué sous une forme numérique), il n'est pas possible à partir d'un signal à 13 MHz, délivré par la référence 12, de disposer par une division par un nombre entier Ms d'un pas de 5,2 MHz. Il aurait fallu diviser par 2,5 qui n'est pas entier. Aussi pour compenser cette difficulté, l'évolution du coefficient Ns, colonne 36, évoluera de deux unités en deux unités.

Ainsi, si on réalise à partir de là un saut de fréquence élémentaire de 200 KHz, on va faire sauter la fréquence de la boucle de translation de 5,2 MHz. Ceci est obtenu en choisissant un coefficient Ms à 622 ce qui amène une fréquence dans cette boucle à 1617,2 MHz. On constate donc qu'on a obtenu un saut de 5,2 MHz par rapport à la situation précédente. Par compensation, dans la boucle 1 on fera progresser le coefficient Ni de 5 unités en décroissant. Il passe ainsi de 98 à 93. Lorsque Ni vaut 93, selon ce qui a été indiqué précédemment, le signal à la fréquence intermédiaire vaut 93 MHz. Par combinaison dans la boucle 3 les signaux à 93 MHz et à 1617,2 MHz conduisent à un signal à 1710,2 MHz. On a donc bien obtenu ainsi le saut de fréquence avec un petit pas (de 200 KHz) en combinant deux grands pas possédant entre eux une différence égale à ce petit pas.

Ainsi de suite, on peut modifier la fréquence d'émission en faisant croître le coefficient Ns de deux unités alors que le coefficient Ni décroît de cinq unités. On peut bien entendu obtenir des fréquences inférieures à 1710 MHz en faisant croître le coefficient Ni à 103 puis 108 et ainsi de suite, et en faisant décroître le coefficient Ns à 618 puis 616 et ainsi de suite.

On constate donc que les variations des coefficients de division Ni et Ns sont liés par une variation de la fréquence d'émission. Lorsque le pas A de variation du coefficient Ni vaut 5, il provoque un pas "a" de variation de fréquence de la fréquence intermédiaire de 5 MHz. Dans la deuxième boucle un pas B de 2 unités de Ns provoque un pas de fréquence "b" de 5,2 MHz de la fréquence de translation. La fréquence d'émission évolue alors avec un pas de fréquence b-a, égal à 200 KHz dans l'exemple.

La fréquence de translation Ft vaut FrefxNs/Ms. De même la fréquence intermédiaire Fi vaut FrefxNi/Mi. Il en résulte que les variations a et b de ces fréquences s'écrivent b=FrefxΔNs/Ms et a=FrefxΔNi/Mi. Or ΔNs est le pas B alors que ΔNi est le pas A. Il en résulte que a/b=(B/Ms)/(A/Mi). On peut en déduire que le rapport Mi/Ms des coefficients diviseurs des diviseurs 13 et 14 respectivement est égal ou proportionnel à Ab/aB. On pourrait par ailleurs choisir un pas a plus grand que le pas b. Dans ce cas, le pas de variation de la fréquence d'émission serait a-b.

Cette manière de faire peut rencontrer une limite, l'aptitude de la boucle 1 à se caler dans toute la dynamique de fréquence désirée. En théorie, le coefficient Ni pourrait ainsi descendre jusqu'à 1. Dans la pratique, on utilise des oscillateurs 17 n'ayant pas une plage d'accord électronique totale. Dans ce cas, on constate que les pas de fréquence a et b peuvent être combinés différemment. Par exemple, sixième ligne du tableau, il est possible d'aboutir à la fréquence d'émission de 1711 MHz de deux manières. Soit le coefficient Ni vaut 73 et le coefficient Ns vaut 630, en continuation logique de la variation de ces coefficients dans les colonnes 34 et 36 respectivement. Soit, de préférence, le coefficient Ni vaut 99 alors que le coefficient Ns vaut 620. Dans ce cas, on aboutit aussi au résultat recherché, mais avec une exploration limitée du coefficient Ni. On joue ainsi sur les valeurs modulo a et modulo b pour produire un résultat modulo a - modulo b, ou modulo a + modulo b qui permette une excursion limitée du coefficient Ni.

La figure 1 montre également schématiquement une autre caractéristique importante de l'invention représentée sous la forme d'une surface grisée 39. La surface grisée 39 montre tous les équipements du modulateur qui peuvent être intégré sur un même circuit intégré. Mis à part les filtres 30 à 33 et ainsi que les oscillateurs commandés en tension 18 et 21, tous les circuits présentés jusqu'ici peuvent être intégrés sur un même circuit intégré 39. Ceci conduit à disposer d'une architecture à très bas coût. Même l'oscillateur 17 peut être intégré sur le circuit intégré 39.

En outre, en sortie de l'oscillateur 18, avant l'entrée dans le mélangeur 27, on place en cascade un diviseur 40 de fréquence par deux. Le diviseur 40 est commutable. Il permet de diviser, ou de ne pas diviser, par deux la fréquence du signal à la fréquence de translation. En pratique un tel diviseur 40 peut permettre de passer du protocole DCS (1800 MHz) au protocole GSM (900 MHz) sans avoir à concevoir un circuit doublé. Le diviseur 40 est aussi intégré de préférence sur le circuit 39.

La figure 1 montre encore qu'à la sortie du duplexeur 24 on peut raccorder un circuit de réception comportant un démodulateur 41 produisant les signaux I et Q (ou NI, et NQ) par mélange, dans des mélangeurs 42 et 43, du signal reçu avec un signal produit par la boucle 2 et passant dans un déphaseur par 90 degrés 44. Le problème du bruit est moins crucial en réception. Dans ce cas, au moment de la réception, les boucles 1 et 3 sont désactivées et la boucle 2 produit directement un signal à la fréquence de réception. Dans cette utilisation le diviseur 14 sera affecté d'un coefficient diviseur Ms valant 65 pour produire une fréquence de comparaison de 200 KHz, alors que le diviseur Ns vaudra 8500 pour que l'oscillateur 18 produise un signal de l'ordre de 1800 MHz dans le cadre du DCS. Dans ce cadre, la démodulation est directe, sans passer par une étape à fréquence intermédiaire.

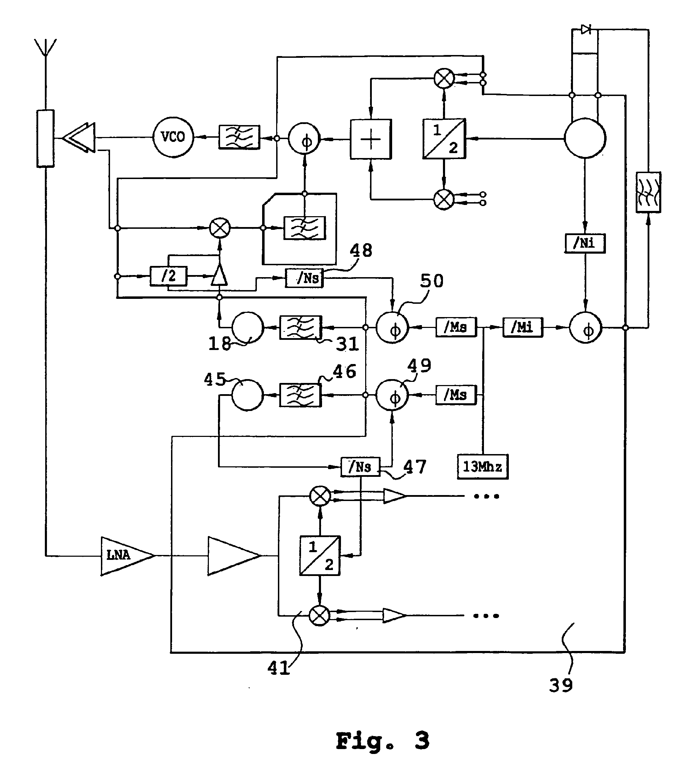

La figure 3 reprend les mêmes éléments que la figure 1 avec la différence toutefois que l'oscillateur 18 ne va pas devoir posséder une dynamique trop importante. On y distingue en effet, un oscillateur 18 devant servir en émission et dont la plage de variation sera typiquement comprise entre 1530 et 1654 MHz, dans le cas du DCS, alors qu'un oscillateur 45 servant en réception possédera une plage évoluant entre 1805 et 1920 MHz dans le cas du DCS également. Par contraste, dans le schéma de la figure 1, l'oscillateur 18 devait avoir une dynamique permettant de couvrir la bande de réception et la bande d'émission, ajoutée à une valeur de la séparation des canaux. En effet, dans le cadre de la téléphonie de type GSM, les canaux d'émission et de réception sont séparés les uns des autres.

Dans un exemple les voies d'émission et de réception ont chacune une bande de 35 MHz et sont espacées de 10 MHz. Avec les deux oscillateurs 18 et 45, chacun d'eux peut avoir une dynamique de variation de fréquence plus faible. Dans ce cas, la boucle 2 est dédoublée pour servir d'une part en émission avec le filtre 31 et l'oscillateur 18, et d'autre part en réception avec un filtre 46 et l'oscillateur 45. Compte tenu des fréquences envisagées, la fréquence de coupure du filtre passe bas 46 peut être de l'ordre de 5 à 10 KHz. De préférence, les diviseurs 47 et 48 et les comparateurs de phase 49 et 50 de chacune de ces boucles sont incorporés dans le circuit intégré 39.

Cette architecture présente surtout l'avantage que les diviseurs 47 et 48 peuvent être conditionnés par anticipation, même avant d'être utilisés, dès qu'on connaît en fait la fréquence de porteuse à laquelle ils doivent participer. On sait par ailleurs que, dans le cadre du GSM, l'évolution en fréquence lors des sauts résulte du traitement d'un algorithme mémorisé dans les téléphones mobiles. Ceux-ci peuvent donc selon l'invention, faire anticiper le traitement de cet algorithme, définir des fréquences de porteuse utilisables dans des fenêtre temporelles futures, en déduire les valeurs des coefficients des diviseurs, et les imposer à ces diviseurs avec suffisamment d'avance temporelle pour que la fréquence régulée dans chacune des boucles de translation soit bien stabilisée au moment où elle doit être utilisée. Le fait de disposer de deux boucles de translation permet par exemple de commencer à conditionner une de ces boucles pendant que l'autre est en plein travail. Donc on n'est pas obligé d'attendre que cette autre boucle ait fini.

Dans la solution de la figure 1, cette anticipation n'est pas recherchée. Pour la réception, on choisit par contre de faire une économie en utilisant des éléments de la boucle 2, alternativement en réception et en émission. Dans ce cas, les filtres 31 ou 46 sont mis en service alternativement dans la boucle 2, au moyen de deux commutateurs 51 et 52 qui leur sont reliés. Au moment de la commutation, bien entendu le coefficient du diviseur 20 doit être changé pour convenir à la synthèse d'une autre porteuse.

## Revendications

1. Chaîne d'émission réception, notamment pour un téléphone mobile, comportant dans un circuit d'émission, une première boucle à verrouillage de phase (1) produisant un signal 1 à une fréquence intermédiaire, une deuxième boucle à verrouillage de phase (2) produisant un signal (5) à une fréquence de translation, et une troisième boucle à verrouillage de phase (3) produisant un signal (6) à une fréquence d'émission, chacune des première, deuxième et troisième boucles de phase comportant son propre oscillateur à fréquence variable (17, 18, 21) commandé par un signal de commande délivré parune voie de contre-reaction comportant, pour-chaque boucle, un comparateurde phase (15, 16, 29) à deux entrées, **caractérisée en ce que** le circuit d'émission comporte en outre un modulateur (7) recevant le signal à fréquence intermédiaire délivré parla première boucle à verrouillage de phase (1), **en ce que** la troisième boucle à verrouillage de phase (3) comprend, dans sa voie de contre-réaction en amont de son comparateur de phase (29), un mélangeur (27) recevant ledit signal à la fréquence d'émission et le signal à la fréquence de translation délivré par la deuxième boucle à verrouillage de phase (2), **en ce que** le comparateur de phase (29) de la troisième boucle à verrouillage de phase (3) reçoit d'une part, un signal délivré par ledit mélangeur (27) dont la fréquence correspond à la différence entre la fréquence d'émission e t la fréquence de translation, et d'autre part le signal issu dudit modulateur (7), de sorte que la valeur de la fréquence d'émission est égale à la somme des valeurs des fréquences intermédiaire et de translation, et **en ce que** la deuxième boucle à verrouillage de phase (2) comporte, dans sa voie de contre-réaction en amont de son comparateur de phase (16), un diviseur de fréquence (48) par un facteur prédéterminé (Ns)et une seconde boucle de translation utilisée dans un circuit de réception, comportant en série son propre oscillateur (45) à fréquence variable commandé en tension, son propre diviseur de fréquence (47), son propre comparateur de phase (49) et son propre filtre passe bas (46).

2. Chaîne selon la revendication 1, **caractérisée en ce que** les diviseurs de fréquence (48, 47) et comparateurs de phase (50, 49) des première et seconde boucles de translation sont intégrés sur un même circuit intégré (39) qui comporte le comparateur de phase (29) de la troisième boucle (3).

## Claims

1. A transceiver chain, notably for a mobile telephone, including in a transmission circuit, a first phase-locked loop (1) producing a signal at an intermediate frequency, a second phase-locked loop (2) producing a signal (5) at a translation frequency, and a third phase-locked loop (3) producing a signal (6) at a transmission frequency, each of the first, second and third phase loops including its own variable frequency oscillator (17, 18, 21) controlled by a control signal delivered by a feedback route including for each loop, a phase comparator (15, 16, 29) with two inputs, **characterized in that** the transmission circuit further includes a modulator (7) receiving the intermediate frequency signal delivered by the first phase-locked loop (1), **in that** the third phase-locked loop (3) comprises in its feedback route upstream from its phase comparator (29), a mixer (27) receiving said transmission frequency signal and the translation frequency signal delivered by the second phase-locked loop (2), **in that** the phase comparator (29) of the third phase-locked loop (3) receives a signal delivered by said mixer (27), the frequency of which corresponds to the difference between the transmission frequency and the translation frequency on the one hand, and the signal from said modulator (7) on the other hand, so that the value of the transmission frequency is equal to the sum of the values of the intermediate and translation frequencies, and **in that** the second phase-locked loop (2) includes, in its feedback route upstream from its phase comparator (16), a frequency divider (48) by a predetermined factor (Ns) and a second translation loop used in a receiving circuit, including in series its own voltage controlled variable frequency oscillator (45), its own frequency divider (47), its own phase comparator (49) and its own lowpass filter (46).

2. The chain according to claim 1, **characterized in that** the frequency dividers (48, 47) and phase comparators (50, 49) of the first and second translation loops are integrated onto a same integrated circuit (39) which includes the phase comparator (29) of the third loop (3).

## Patentansprüche

1. Sende-Empfänger, insbesondere für ein Mobiltelefon, mit einem Sendekreis, einer ersten Phasenverriegelungsschleife (1), die ein Signal mit einer Zwischenfrequenz erzeugt, einer zweiten Phasenverriegelungsschleife (2), die ein Signal (5) mit einer Translationsfrequenz erzeugt, und einer dritten Phasenverriegelungsschleife (3), die ein Signal (6) mit einer Sendefrequenz erzeugt, wobei jede der Phasenverriegelungsschleifen eins, zwei und drei ihren eigenen durchstimmbaren Oszillator (17, 18, 21) besitzt, der durch ein Steuersignal gesteuert wird, das über einen Rückkopplungsweg geliefert wird und für jede Schleife einen Phasendetektor (15, 19, 29) mit zwei Eingängen besitzt, **dadurch gekennzeichnet, dass** der Sendekreis darüberhinaus einen Modulator (7) besitzt, der das Zwischenfrequenzsignal empfängt, das von der ersten Phasenverriegelungsschleife (1) geliefert wird, dass die dritte Phasenverriegelungsschleife (3) in ihrem Rückkopplungsweg vor ihrem Phasendetektor (29) einen Mischer (27) besitzt, der das Sendefrequenzsignal und das Translationsfrequenzsignal empfängt, das von der zweiten Phasenverriegelungsschleife (2) geliefert wird, dass der Phasendetektor (29) der dritten Phasenverriegelungsschleife (3) einerseits ein Signal empfängt, das von dem Mischer (28) geliefert wird, dessen Frequenz der Differenz zwischen der Sendefrequenz und der Translationsfrequenz entspricht, und andererseits das Signal empfängt, das von dem Modulator (7) stammt, so dass der Wert der Sendefrequenz gleich der Summe der Werte der Zwischenfrequenz und der Translationsfrequenz ist, und dass die zweite Phasenverriegelungsschleife (2) in ihrem Rückkopplungsweg vor ihrem Phasendetektor (16) einen Frequenzteiler (48) durch einen vorbestimmten Faktor (Ns) besitzt, und eine zweite Translationsschleife, die in einem Empfangskreis verwendet wird, in Reihe ihren eigenen durchstimmbaren, spannungsgesteuerten Oszillator (45), ihren eigenen Frequenzteiler (47), ihren eigenen Phasendetektor (49) und ihren eigenen Tiefpassfilter (46) besitzt.

2. Sende-Empfänger nach Anspruch 1, **dadurch gekennzeichnet, dass** die Frequenzteiler (48, 47) und Phasendetektoren (50, 49) der ersten und zweiten Schleife in denselben integrierten Schaltkreis (39) integriert sind, der den Phasendetektor (29) der dritten Schleife (3) aufweist.
